# EUROPEAN PATENT SPECIFICATION

(11) **EP 0 907 208 B1**
(45) Date of publication and mention of the grant of the patent: **18.12.2002**
(21) Application number: 97830490.5
(22) Date of filing: 02.10.1997
(51) Int. Cl.: H01L 27/085, H01L 27/098, H01L 21/8232

(54) **Process of producing a JFET device**
Verfahren zur Herstellung eines JFET Bauelements
Procédé pour la fabrication d'un dispositif JFET

(43) Date of publication of application: 07.04.1999
(73) Proprietor: ISTITUTO TRENTINO DI CULTURA, 38100 Trento (IT)
(72) Inventor: Bellutti, Pierluigi, 38050 Povo (Trento) (IT); Boscardin, Maurizio, 38068 Rovereto (Trento) (IT); Zorzi, Nicola, 38040 Lavarone (Trento) (IT); Dalla Betta, Gian-Franco, 31041 Cornuda (Treviso) (IT)
(74) Representative: Quinterno, Giuseppe

(56) References cited:
- EP-A- 0 569 204
- EP-A- 0 676 802
- WO-A-94/19828
- DE-A- 2 753 704
- US-A- 4 118 728
- PATENT ABSTRACTS OF JAPAN vol. 018, no. 105 (E-1512), 21 February 1994 -& JP 05 304258 A (TOSHIBA CORP;OTHERS: 01), 16 November 1993,
- P. BELLUTTI ET AL: "Proposal for a simplified CMOS VLSI Fabrication Sequence" IEE MANUFACTURING DIVISION COLLOQIUM ON IMPROVING THE EFFICIENCY OF IC MANUFACTURING TECHNOLOGY, LONDON, 12. 04.1995, IEE COLLOQIUM DIGEST, no. 153, 1995, STEVENAGE, ENGLAND, pages 3/1-3/4, XP002057106

## Description

The present invention relates to the fabrication of JFET devices (Junction Field Effect Transistors).

Devices of this type constitute an important option available to the designer for the production of low noise circuits and in particular for charge amplification. JFETs can moreover provide good performance from the dynamic point of view and can therefore be used in wideband amplifier stages. A further advantage related to JFETs is their intrinsic resistance to damage by radiation ("rad-hard"), a fact that can make their use preferential over the use of MOSFETs in environments in which ionising radiation is present, for example in space vehicles.

In PATENT ABSTRACTS of JAPAN vol. 018, No. 105 (E-1512), 21 February 1994 - & JP 05 304 258 A, 16 November 1993 there is disclosed (specifically with reference to figures 6-8) a process for producing a semiconductor device wherein CMOSFETs and JFETs are hybridised. The semiconductor device comprises a substrate with a MOSFET region and JFET region. The fabrication process includes an impurity implantation (as in a CMOS process) in the intended channel region of a JFET, followed by the growth of a LOCOS-type isolating oxide layer which entirely covers the channel region. Said oxide layer is then partially removed, by means of a suitable mask, so as to leave the channel region accessible in the subsequent process steps.

The present invention, as defined in claim 1, is essentially based on the recognition of the possibility of automatically obtaining a JFET device within a normal CMOS process with LOCOS type isolation.

As is known, the term LOCOS indicates a process utilised in the fabrication of semiconductor electronic circuits to provide electronic and/or physical isolation between adjacent devices. In the LOCOS process a layer of silicon nitride is deposited on the preliminarily oxidised silicon substrate (pad oxide) and then defined by way of lithography so as to leave the nitride in the regions where the devices are located (active regions). The nitride is then removed from the areas between the devices where, on the other hand, there is created a thick insulating layer of oxide (LOCOS = Local Oxidation of Silicon).

For a general discussion on the subject reference can usefully be made to the article "DW-LOCOS: a convenient VLSI isolation technique" by P. Bellutti, M. Boscardin, G. Soncini, M. Zen e N. Zorzi, published in Semicond. Sci. Technol. 10 (1995), PP. 1700-1705.

The invention will now be described purely by way of non limitative example, with reference to the attached drawings, in which:
- Figure 1 schematically illustrates the structure of a JFET device ;
- Figures 2 to 4 schematically illustrate successive stages in the fabrication process of the invention; and
- Figures 5 and 6 illustrate the operating characteristics of a device according to the invention.

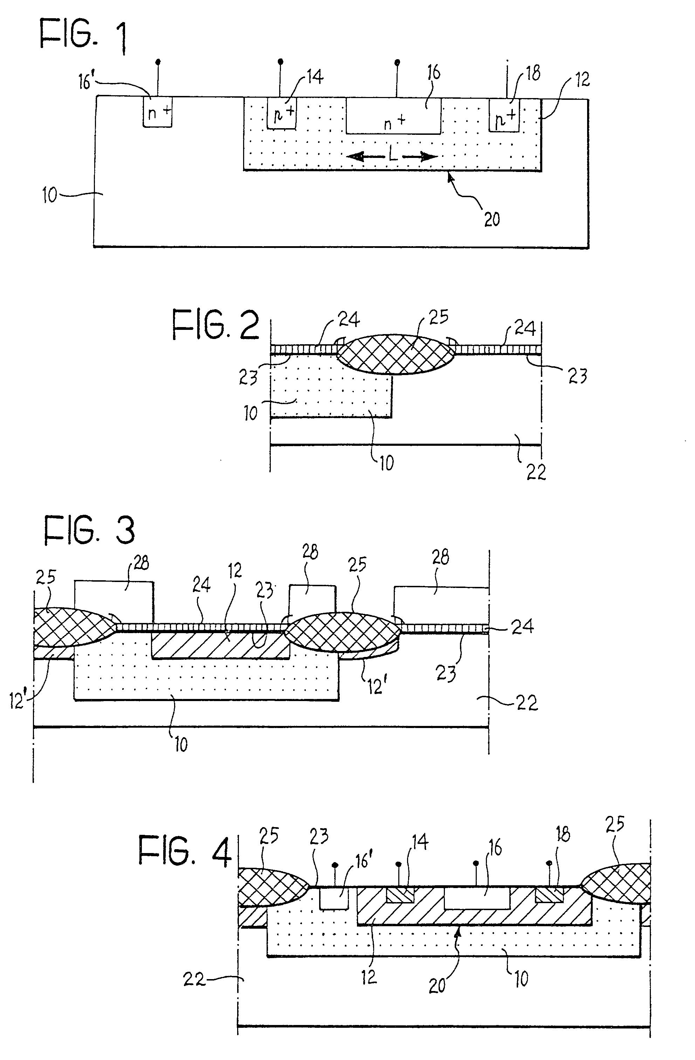

The general structure of a JFET device is shown in Figure 1 where the reference 10 indicates a silicon substrate of n-type in which is formed an island or zone 12 of p-type silicon intended to define the channel of the FET. The references 14, 16, 18 indicate respective semiconductor zones defining the source contact (source, doped p⁺), the top gate contact (top gate, doped n⁺) and the drain contact (drain, doped p⁺). The reference 16' indicates the so-called bottom gate contact (bottom gate, also doped n⁺), located outside the island or zone 12, but substantially similar in nature to the top gate zone 16.

As is well known, an electric current is caused to flow in the device by the application of a potential difference across the terminals of the source 14 and drain 18. The flow of current is controlled by the reverse voltage applied to the gate 16: this latter, by modulating the depletion depth, controls the concentration of the charge carriers in the channel zone indicated 20.

For a deeper treatment of these aspects reference can usefully be made to any basic text relating to semiconductor electronics such as, for example, the well known text "Physics of Semiconductor Devices" by S.M.Sze, Wiley-Interscience, 1969.

In summary, the process for producing the device shown in Figure 1 provides for the performance of a first diffusion to obtain the p-type zone or island indicated 12 and a subsequent n-type diffusion to obtain the gate n⁺ indicated 16. The depth of this latter diffusion with respect to the previous one defines the thickness of the channel 20 of the JFET.

This structure is in fact compatible with bipolar and CMOS type integrated circuit fabrication processes. However, the thickness (depth) of the channel 20 and its doping make the JFET structure one which is automatically attainable with bipolar technology, whilst it requires the addition of a photolithographic step and an implantation step to standard CMOS technology.

DW-LOCOS CMOS technology described for example in the Bellutti et al bibliographic reference cited above, offers the possibility of producing JFET structures without the addition of any further technological steps. In particular, the solution according to the invention makes it possible to form the JFET channel by exploiting the isolation implant (channel stop) of the CMOS process. The same channel stop mask, suitably modified, is in fact utilised as the mask.

The process according to the invention is illustrated in greater detail in Figures 2 to 4, which illustrate three successive stages in the said fabrication process.

As is evident to the man skilled in the art, the said stages incorporate the results of successive treatment phases which will be discussed in more detail hereinafter: the general criteria for performing these phases and the corresponding technologies are widely known per se in the art and do not therefore require to be illustrated in detail here.

Although the solution illustrated here by way of example is for the production of a p-channel JFET device it is however evident that the same solution could be adopted, with modifications within the scope of the man skilled in the art, to form n-channel JFET devices.

Figure 2 schematically illustrates a first intermediate stage in the production of a JFET device according to the invention resulting from growing a layer of oxide 23 on a base substrate 22 of p-type, and defining an n-type drain corresponding to the zone indicated 10 in Figure 1 with associated implantation of phosphorus. This is followed by deposition of a surface layer 24 of silicon nitride with subsequent definition of the active area by means of dry etching of the nitride and drive-in of the drain 10 following oxidation. This latter gives rise to the growth of the isolating oxide 25 (LOCOS).

Figure 3 illustrates the intermediate product shown in Figure 2 after the further operations (definition and implantation of high energy boron) which lead to the production of the p-type zone indicated 12 and similar adjacent zones indicated 12' so as to provide the known channel-stop function, here of p-type. The reference numeral 28 naturally indicates the layer of photo resist utilised as a mask in the above-described operations.

Figure 4 illustrates the JFET device corresponding to the structure represented in Figure 1 obtained after the following operation/treatment stages (on the intermediate product shown in Figure 3):
- removal of the photoresist,
- removal of the nitride, for example by wet etching,
- implantation for adjustment of the thresholds,
- growth and subsequent removal of a layer of sacrificial oxide,
- growth of the gate oxide relating to the CMOS part,
- deposition, definition and dry etching of the polysilicon,
- definition and implantation (for example As, P or As + P) of the n⁺ of the top gate 16 and simultaneous definition and implantation of the bottom gate contact 16' outside the zone 12,
- drive-in of these,
- definition and implantation of p⁺ diodes (BF2),
- deposition and reflow of the dielectric.

It will be noted that the overall sequence of operations just described did not involve additional technological steps over a normal CMOS process.

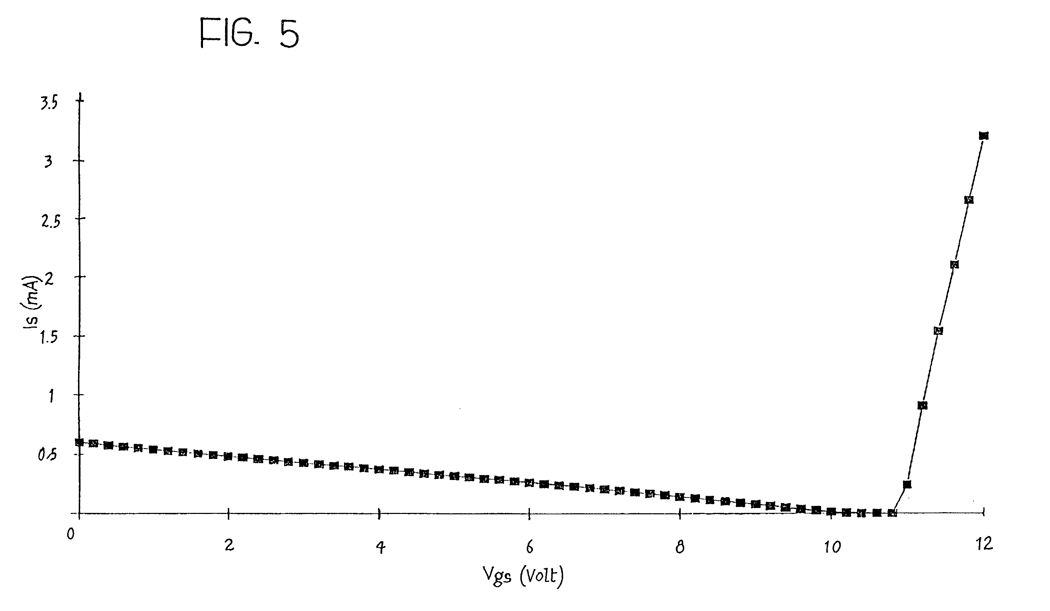

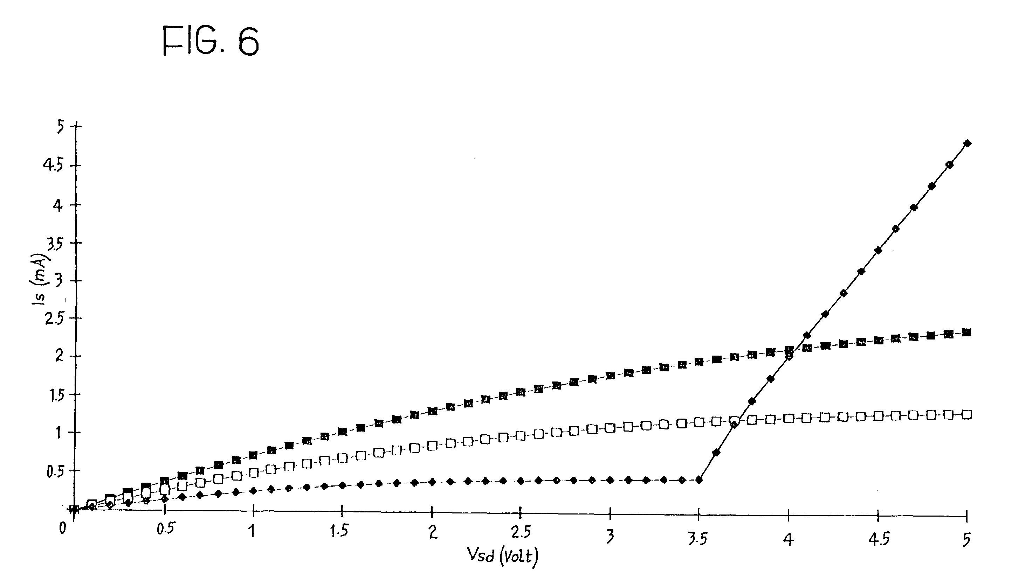

The diagram of Figure 5 illustrates the typical transcharacteristic curve (source current Is - along the ordinate - as a function of the gate-source voltage Vgs - along the abscissa - with drain-source voltage Vds equal to 0.5 Volt) of a JFET device manufactured by a process according to the invention. The diagrams of Figure 6 on the other hand illustrate typical characteristic curves of the source output current Is - along the ordinate - as a function of the source-drain voltage Vsd - along the abscissa - for different values of the gate-source voltage Vgs respectively equal to 0 volts (solid square curve) 4 volts (empty square curve) and 8 Volts (rhombus curve).

The results experimentally summarised in Figures 5 and 6 show that the structures obtained have a pinch off voltage of about 10 volts (see in particular Figure 5) slightly less than the breakdown voltage of the gate-channel junction (16-12 in Figure 4). Further experimentation conducted by the applicant shows however that it is possible to reduce the said pinch-off voltage whilst nevertheless maintaining the functionality of the CMOS part. In particular, the applicant has succeeded in producing structures according to the invention having a pinch-off voltage of the order of 0.1 Volt without any contraindication on the corresponding CMOS. It can therefore reasonably be expected that all of the above-mentioned voltage intervals can be considered such as to guarantee the reliability of the CMOS with the consequent possibility of producing working voltage values adapted to specific application and operating requirements (for example working voltages of the order of 1 to 2 volts) by acting on the associated technological variables.

Naturally, the principle of the invention remaining the same, the details of construction and the embodiments can be widely varied without departing from the scope of the claims 1-5.

## Claims

1. A process of producing a JFET device having a first semiconductor zone (12) of a first conductivity type and a second semiconductor zone (16) of a second opposite conductivity type formed in said first semiconductor zone and serving as a top gate, said first and second zones defining a channel region (20) between source and drain regions (14, 18) in the said first zone (12); the said first and second zones (12, 16) together defining a junction which allows the concentration of charge carriers to be controlled in the said channel region (20);
the process comprising the steps of
growing LOCOS-type isolating oxide (25) on a substrate (22) only outside the region of said substrate intended to contain said channel region (20); and
subsequently forming by using a mask and an isolation implantation of a CMOS manufacturing process said first semiconductor zone (12) in the substrate and a laterally separated channel stop region (12') in the substrate by using said isolation implantation through said LOCOS-type isolating oxide (25);
whereby the JFET device is obtained by a CMOS manufacturing process with LOCOS-type isolation, without any additional technological steps.

2. A process according to Claim 1, wherein said isolation implantation is formed by implanting boron ions.

3. A process according to any preceding claim, including the formation of a third semiconductor zone (14) and a fourth semiconductor zone (18) within the said first semiconductor zone (12), the said third and fourth semiconductor zones (14, 18) constituting the source and the drain of the JFET device.

4. A process according to Claim 1, wherein the diffusion of the said second semiconductor zone (16) into the said first semiconductor zone (12) simultaneously defines the top gate of the channel (20) of the JFET device and the thickness of the said channel (20).

5. A process according to any of Claims 1, 3 or 4, including the operation of providing, simultaneously with the said second zone (16), a further zone (16') acting as a bottom gate contact of the JFET device; the said further zone (16') being substantially similar to the said second zone (16) and being located outside the said first zone (12).

## Patentansprüche

1. Verfahren zur Herstellung einer JFET-Vorrichtung mit einer ersten Halbleiterzone (12) von einem ersten Konduktivitätstyp und einer zweiten Halbleiterzone (16) von einem zweiten entgegengesetzten Konduktivitätstyp, die in dieser ersten Halbleiterzone gebildet ist und als oberes Gate dient, wobei die erste und die zweite Zone zwischen dem Source- und dem Drain-Bereich (14, 18) in der ersten Zone (12) einen Kanalbereich (20) definieren; die erste und die zweite Zone (12, 16) zusammen eine Verbindung definieren, welche die Steuerung der Konzentration von Ladungsträgern in diesem Kanalbereich (20) gestattet;
wobei das Verfahren die folgenden Schritte umfasst:
das Wachsenlassen eines Trennoxids vom LOCOS-Typ (25) auf einem Substrat (22) nur außerhalb des Bereichs dieses Substrats mit der Bestimmung, den Kanalbereich (20) zu enthalten; und
die anschließende Bildung der ersten Halbleiterzone (12) im Substrat durch Anwendung einer Maske und einer Isolationsimplantierung eines CMOS-herstellenden Verfahrens sowie eines seitlich getrennten Kanalsperrbereichs (12') im Substrat durch Anwendung der Isolationsimplantierung durch das Trennoxid vom LOCOS-Typ (25);
wobei die JFET-Vorrichtung durch ein CMOS-herstellendes Verfahren mit einer Isolierung vom LOCOS-Typ erhalten wird, und zwar ohne irgendwelche zusätzlichen technologischen Schritte.

2. Verfahren nach Anspruch 1, wobei die Isolationsimplantierung durch die Implantierung von Borionen gebildet wird.

3. Verfahren nach einem der vorhergehenden Ansprüche, einschließlich der Bildung einer dritten Halbleiterzone (14) und einer vierten Halbleiterzone (18) innerhalb der ersten Halbleiterzone (12), wobei die dritte und die vierte Halbleiterzone (14, 18) die Source und den Drain der JFET-Vorrichtung bilden.

4. Verfahren nach Anspruch 1, wobei die Diffusion der zweiten Halbleiterzone (16) in die erste Halbleiterzone (12) gleichzeitig das obere Gate des Kanals (20) der JFET-Vorrichtung und die Dicke des Kanals (20) definiert.

5. Verfahren nach einem der Ansprüche 1, 3 oder 4, einschließlich der Funktion des Schaffens einer als unterer Gate-Kontakt der JFET-Vorrichtung wirkenden weiteren Zone (16') gleichzeitig mit der zweiten Zone (16); wobei die weitere Zone (16') im Wesentlichen der zweiten Zone (16) ähnelt und sich außerhalb der ersten Zone (12) befindet.

## Revendications

1. Procédé de production d'un dispositif JFET ayant une première zone semi-conductrice (12) d'un premier type de conductivité et une deuxième zone semi-conductrice (16) d'un deuxième type de conductivité opposé formée dans ladite première zone semi-conductrice et servant de grille supérieure, lesdites première et deuxième zones définissant une région de canal (20) entre des régions de source et de drain (14, 18) dans ladite première zone (12) ; lesdites première et deuxième zones (12, 16) définissant ensemble une jonction qui permet la concentration de porteurs de charge à commander dans ladite région du canal (20) ;
le procédé comprenant les étapes consistant à
faire croître un oxyde isolant (25) de type LOCOS sur un substrat (22) seulement à l'extérieur de la région dudit substrat prévu pour contenir ladite région du canal (20) ; et
former ultérieurement, en utilisant un masque et une implantation isolante d'un procédé de fabrication CMOS, ladite première zone semi-conductrice (12) dans le substrat et une région d'arrêt de canal latéralement séparée (12') dans le substrat en utilisant ladite implantation isolante à travers ledit oxyde isolant de type LOCOS (25) ;
le dispositif JFET étant obtenu par un procédé de fabrication CMOS avec une isolation de type LOCOS, sans étapes technologiques supplémentaires.

2. Procédé selon la revendication 1, dans lequel ladite implantation isolante est formée en implantant des ions de bore.

3. Procédé selon l'une quelconque des revendications précédentes, incluant la formation d'une troisième zone semi-conductrice (14) et d'une quatrième zone semi-conductrice (18) à l'intérieur de ladite première zone semi-conductrice (12), lesdites troisième et quatrième zones semi-conductrices (14, 18) constituant la source et le drain du dispositif JFET.

4. Procédé selon la revendication 1, dans lequel la diffusion de ladite deuxième zone semi-conductrice (16) dans ladite première zone semi-conductrice (12) définit simultanément la grille supérieure du canal (20) du dispositif JFET et l'épaisseur dudit canal (20).

5. Procédé selon l'une quelconque des revendications 1, 3 ou 4, incluant l'opération de fourniture, simultanément avec ladite deuxième zone (16), d'une zone supplémentaire (16') agissant comme un contact de grille inférieure du dispositif JFET ; ladite zone supplémentaire (16') étant sensiblement similaire à ladite deuxième zone (16) et étant localisée à l'extérieur de ladite première zone (12).
